(19) **Europäisches Patentamt / European Patent Office / Office européen des brevets**

(11) **EP 1 998 265 A1**

(12) **EUROPEAN PATENT APPLICATION**

(43) Date of publication:
**03.12.2008 Bulletin 2008/49**

(51) Int Cl.:
**G06F 17/50** (2006.01)

(21) Application number: **08157293.5**

(22) Date of filing: **30.05.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **01.06.2007 JP 2007147520**

(71) Applicant: **Inventure Inc.**
**Yokohama, Kanagawa 222-8505 (JP)**

(72) Inventors:
• **Ando, Hironori**
**Yokohama Kanagawa 222-8505 (JP)**

• **Nakamura, Takashi**
**Yokohama Kanagawa 222-8505 (JP)**
• **Nakamura, Tatsuya**
**Yokohama Kanagawa 222-8505 (JP)**
• **Seki, Kazunori**
**Yokohama Kanagawa 222-8505 (JP)**

(74) Representative: **Moser & Götze**
**Patentanwälte**
**Paul-Klinger-Strasse 9**
**45127 Essen (DE)**

(54) **Method for designing LSI (Large Scale Integration) system and design support device for LSI system**

(57) A method and a device for designing a system comprising a PCI Express (PCIe) bus. A development board comprising a first design of the PCIe is plugged into a target device. Data transfers between the PCIe board and the target device are monitored and the size and number of stages of the Rx/Tx buffers of the board are changed in order to meet the design specification.

Fig.1

EP 1 998 265 A1

**Description**

CROSS REFERENCE TO RELATED APPLICATION

The present disclosure relates to subject matter contained in Japanese Patent Application No. 2007-147520 filed on June 1, 2007, the disclosure of which is expressly incorporated herein by reference in its entirety.

BACKGROUND OF THE INVENTION

Field of the Invention

The present invention relates to a method for designing LSI system, a design support device for LSI system. In particular, the present invention relates to a method for designing LSI system and a design support device for LSI system which are able to design the most desirable function block realizing a high speed serial bus such as PCI Express, evaluate the most desirable function block, and construct a virtual function block before manufacturing an actual LSI system.

Description of the Related Art

As a high-speed serial interface, PCI Express (registered trademark), a subsequent standard of PCI bus method, is proposed (e.g., see "Outline of the PCI Express Standard", Interface, July 2003 Satomi Naoshi). The system having PCI Express (PCIe) inevitably establishes one to one link between an upper component and a lower component. The link corresponds to lanes which are bundles of transmitted and received differential signals. The link is composed of lanes. And 1 lane, 2 lanes, 4 lanes, 8 lanes, 12 lanes, 16 lanes, and 32 lanes are standardized. In the PCI Express transfer method, a division transfer method is adopted for "post transfer" such as a memory writing request and a memory reading transfer. The division transfer method is classified roughly into a "nonpost transfer" such as a reading instruction and a "completion transfer" such as a reading response. The division transfer method is controlled by a credit based type of flow control, which is a mechanism conducting interlink communications by monitoring the buffers capacities of each communication counterpart.

The transfer rate of PCI Express is 2.5 Gbps or 5 Gbps per direction per lane. The transfer rate of PCI Express accompanies loss associated with 8B/10B coding. Also, since communication packets (e.g., transaction layer packet (TLP)) are divided and transferred based on the maximum reading request size and the maximum payload size defined between links, packet header overhead will be generated. In addition, there are data link layer packets such as ACK/NAK DLPP and ACK/NAK DLPP for ensuring data completeness of the TLP. The ACK/NAK DLLP informs that a TLP is normally or abnormally transmitted to a reception side. The Update-FC DLLP informs buffer capacity of a transmission counterpart. Furthermore, a lower layer packet such as an SKP order set, which is periodically inputted in order to maintain certain interlink clock phase difference, may interrupt. Therefore, the effective transfer rate of PCI Express deteriorates due to various factors.

In a conventional LSI designing method, after having built a function block for realizing high speed serial interface, the performance of the function block is evaluated. This designing process does not always realize a function block having the most desirable effective transfer rate, or forms excessive lanes and buffers. The PCI Express is designed to form a communication link between communication counterparts on a one-to-one basis. Therefore, a PCI Express function block considering a transfer band cannot be developed without having information on receiving buffer, response time, of a communication counterpart.

SUMMARY OF THE INVENTION

An LSI system can be built by using the LSI design support device of the present invention. Before building the LSI system, the LSI design system of the present invention is connected with a connection component. Then, the most desirable link structure is determined by creating various information transfer environments while changing lanes and buffer structures within the LSI design support device. The link structure includes the number of lanes and the structures of transmission/reception buffers (e. g., the number of stages and the buffer capacity). In this way, the structure of the function block achieving high speed serial interface, such as a PCI Express function block can be determined.

After having built a PCI Express function block within the LSI design system, an application function block is connected with the PCI Express function block within the LSI design system. The application function block and the PCI Express function block are built in the LSI design system, but are not built in an actual LSI system. They are models to be built in the actual LSI system in the future. In this way, a virtual LSI system is built in the LSI design system. The LSI design system has a function block creating high transfer load conditions, and can control the number of lanes, the buffer structure. Therefore, error states and various abnormal situations can be generated intestinally within the LSI design system. The LSI design system of the present invention can evaluate transfer capacity of the virtual LSI system in the various abnormal situations. In addition, various parameters obtained in the evaluation process can be utilized for the development of software implemented in actual products.

In this way, several types of information (parameters) required for designing an LSI system are stored in the LSI design support device. Thus, an LSI system having the most desirable PCL Express function block can be built by using information for designing an LSI system outputted from an output device.

In conducting the above process, several types of information (parameters) on an object system are stored within the LSI design support device. The LSI design support device is also able to change the number of lanes, the number of stages of transmission/reception buffer, the buffer capacity. Therefore, the LSI design support device is also able to build a virtual object system within the LSI design support device. The virtual connection system thus built can be connected to the actual LSI system. In general, it is difficult for the object system to change communication speed. However, the LSI design support device of the present invention can change specifications such as communication speed. Therefore, the device is also able to create anomaly situations of the object system. Thus, the device can evaluate characteristics of the actual LSI system such as endurance thereof when an anomaly is generated in the object system.

The present invention relates to a design method for designing an LSI system having a high speed serial bus and a function block for realizing the high speed serial bus, the method comprising:

connecting an LSI design support device with an object system, the object system to be connected to the LSI system; and
the LSI design support device determining the most desirable number of stages of transmission/reception buffers and the most desirable transmission/reception buffer capacity for the function block,

wherein the determination is realized by measuring a link communication rate between the LSI design support device and the object system by monitoring number of transmission packets or reception packets, the transmission packets being transmitted to the object system, and by monitoring response time of the object system to the packets, while changing number of stages of transmission/reception buffers and transmission/reception buffer capacity of the LSI design support device.

A preferred embodiment of the present invention is the above described LSI system design method comprising:

connecting an LSI design support device with an object system, the object system to be connected to the LSI system; and
the LSI design support device determining the most desirable number of lanes and the most desirable transmission/ reception buffer structure,
wherein the determination of the most desirable number includes:

calculating an effective transmission rate of each lane by considering an overhead of a communication packet header, the overhead being set at each link of the LSI design support device, and calculating required number of lanes by comparing the effective transmission rate and an effective transmission rate per lane,
where these calculations are performed so that, when a number of lanes currently establishing links is supposed to be the maximum number of lanes, the number of lanes becomes no more than the maximum number of lanes and satisfies a required transmission band; and
monitoring a number of transmission packets or reception packets and response time to the packets, while changing the number of lanes of the LSI design support device and changing headers and payload size of the transmission/reception buffers of the LSI design support device.

A preferred embodiment of the present invention is the above described LSI system design method, wherein the high speed serial bus is a high speed serial bus based on the PCI Express standard.

A preferred embodiment of the present invention is in accordance with any of the above described method, and the method further comprising a step of building a function block within the LSI design support device, the function block having the most desirable number of lanes, the most desirable number of stages of a transmission/reception buffer, and the most desirable transmission/reception buffer capacity for the function block, the function block having the same function as a function block to be built in the LSI system.

A preferred embodiment of the present invention is a method for manufacturing a virtual LSI system using the LSI design support system, the system comprising an application function block, the application function block being used for the LSI system,
the method further comprising a step of connecting the application function block and the function block, the function block being built by the method for building a PCI Express virtual function block as indicated above

A preferred embodiment of the present invention is a performance evaluation method for the LSI system using an LSI design support device, the LSI design support device comprising a virtual LSI system being built by the manufacturing method as described the above.

A preferred embodiment of the present invention is a method for manufacturing an LSI system comprising:

outputting a design parameter for an LSI system obtained by the performance evaluation method as explained above, manufacturing an actual LSI system by using the outputted design parameter for an LSI system.

The LSI system design parameter may include information on number of lanes, transfer speed, a transmission/reception buffer structure as needed. Also, the LSI system may be manufactured based on information used for building a virtual LSI system.

A preferred embodiment of the present invention is a method for manufacturing a virtual object system using the method for manufacturing the virtual LSI system as explained the above,
wherein information on reception buffer structures of the object system is obtained and response speed of the object system is measured when the virtual LSI system is built,
the method further comprising a step of changing number of lanes and transmission/reception buffer structures of the LSI design support device according to the obtained reception buffer structures and the response speed,
thereby building a virtual object system within the LSI design support device, the system being able to be connected with an actual LSI system.

A preferred embodiment of the present invention is a performance evaluation method for an LSI system comprising:

connecting a virtual object system and an LSI system, the virtual object system being manufactured by the method for manufacturing a virtual object system as explained above, the LSI system being manufactured by the method for manufacturing an LSI system explained above; and
evaluating performance of the LSI system by changing one or more of a number of lanes, a number of stages of transmission/reception buffers, a transmission/reception buffer capacity, and a transmission load capacity of the virtual object system.

A preferred embodiment of the present invention is an LSI system design support device for designing an LSI system having a high speed serial bus and a function block for realizing the high speed serial bus, the device comprising:

a high speed serial bus to be connected with a high speed serial bus of an object system, the object system to be connected to the LSI system;
a means for reading information from the object system, the information including a maximum number of lanes for the high speed serial bus, transmission/reception buffer information of the function block, a maximum reading capacity of the object system, and a maximum payload capacity of an object system;
a means for changing a number of lanes of the high speed serial bus, the high speed serial bus to be connected with the object system;
a means for changing a number of stages of transmission/reception buffers and a transmission/reception buffer capacity;
a means for monitoring a number of a transmission packet or a reception packet and a response time of an LSI system to the packets;
a means for analyzing a number of transmission packets or reception packets and a communication speed of the object system to the packets based on the monitored response time; and
a means for determining a most desirable number of stages of the transmission/reception buffers and a most desirable transmission/reception buffer capacity for the function block based on analysis results.

A preferred embodiment of the present invention is an LSI system design support device as explained above, wherein the high speed serial bus is a high speed serial bus based on the PCI Express standard.

The present invention can provide a method for designing a function block realizing a high speed serial bus having the most desirable number of lanes and the most desirable buffer structure, and a method for designing an LSI system having the function block.

The present invention can provide a method for manufacturing a virtual function block having the same specifications as a function block realizing a high speed serial bus before building an actual function block.

The present invention can provide a design support device for designing a function block realizing a high speed serial bus having the most desirable number of lanes and the most desirable buffer structure, and a design support device for an LSI system having the function block.

The present invention can provide a method for designing a function block realizing a high speed serial bus having the most desirable number of lanes and the most desirable buffer structure, and to provide a function block and an LSI system built by a method for designing an LSI system having the function block.

BRIEF DESCRIPTION OF THE DRAWINGS

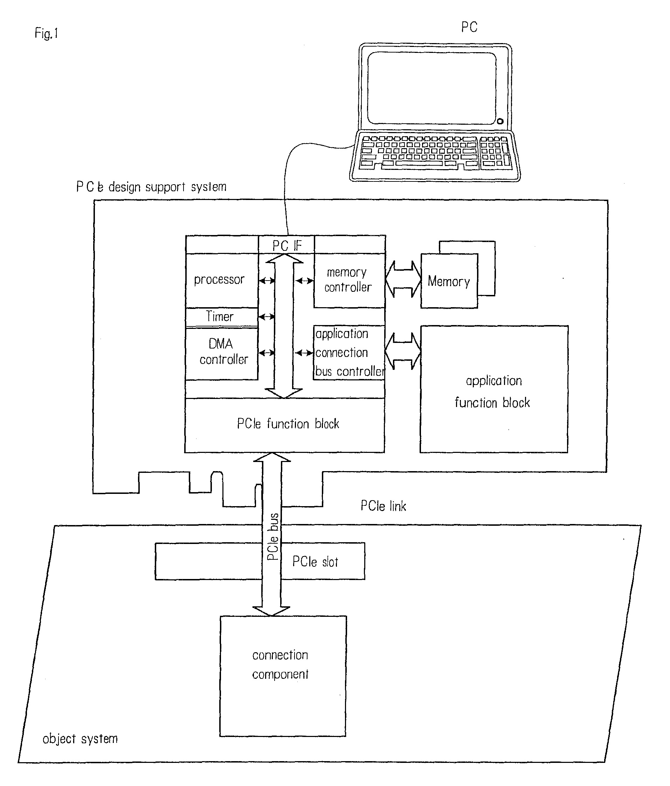

Fig.1 is a conceptual diagram showing a structure of an LSI design support device and an exemplary connection between the LSI design support device and an object system.

DESCRIPTION OF THE PREFFERED EMBODIMENTS

A Structure of an LSI Design Support Device

Fig.1 is a conceptual diagram showing a structure of an LSI design support device and an exemplary connection between the LSI design support device and an object system. As shown in Fig.1, the LSI design support device includes an interface "PC IF" for connecting the device and an external control device, such as an external PC, a processor for conducting various arithmetic processing, a timer for measuring a transfer band rate, a DMA controller for realizing a high load transfer, a memory controller for controlling a memory being connected with a memory such as buffers, an application function bus controller (connected to an application connection bus controller) for connecting the LSI design support device with an application function block, and a PCI Express (PCIe) function block. Each component is connected via bus so as to be able to exchange information. The LSI design support device also includes a mechanism for controlling link information between the LSI design support device and an LSI system, a mechanism for analyzing a transfer factor, a mechanism for outputting a direction for building a desirable function block within the LSI design support device.

An LSI system having a high speed serial bus, for example, has a slot based on the PCI Express. The LSI design support device also has a terminal portion fitting into the slot. So, the high speed serial bus of the LSI system can be connected with the LSI design support device by plugging the terminal portion of the LSI design support device into a PCI Express slot of the LSI system.

The LSI design support device, having received a direction from the computer for controlling the LSI design support device, initiates a DMA controller and creates a high load transfer condition. While the LSI system is being operated, the LSI design extracts and processes information stored in the LSI design support device and keeps changing the structure of the PSI Express function block dynamically. In this way, the device determines the structure of the LSI design support device for realizing transfer capacity requiring.

In particular, the LSI design support device reads out information including the maximum number of lanes for the LSI system high speed serial bus, transmission/reception buffer information of the function block, a maximum reading capacity, and a maximum payload capacity from the object system. Also, the LSI design support device reads out information on a reception buffer structure of the object system.

The LSI design support system determines the desirable number of lanes for the function block. In particular, the LSI design support system measures link communication rate between the LSI design support device and the object system through monitoring number of a transmission packet or a reception packet and response time of the object system to the packets by using the maximum reading size and the maximum size, and determines the desirable number of lanes for the function block. This number of lanes is designed so as to be below the maximum number of lanes and satisfy required transfer band. A preferred embodiment of determining the desirable number of lanes is as follows. An effective transfer rate of each lane is calculated considering an overhead of a communication packet header which is set at each lane between the LSI design support device and the object system. Number of lanes required is calculated by comparing the above effective transfer rate and an effective transfer rate per lane. And number of a transmission packet or a reception packet and a response time of the object system to the packets are monitored while changing number of lanes of the LSI design support device. As have been described, it is preferred for the LSI design support device to be able to control number of lanes dynamically.

The LSI design support system monitors number of a transmission packet or a reception packet and response time of the object system to the packets while changing number of stages of transmission/reception buffers and transmission/reception buffer capacity of the LSI design support device. In this way, the LSI design support system measures a link communication rate between the LSI design support device and the object system, and determines the most desirable number of stages of transmission/reception buffers and the most desirable transmission/reception buffer capacity for the function block.

This is realized, in particular, as follows. The DMA controller creates a high load transfer condition. The link communication rate between object components is measured while changing number of stages of the header and the payload capacity of the transmission/reception buffers within the PCI Express function block. Then, a minimum transmission/reception buffer structure that satisfies a required transfer band is determined. Specifically, the most desirable buffer structure can be figured out by the LSI design support device which is provided with means for varying header and payload of a transmission/reception buffer. In this way, minimum structures (lane structures and buffer structures) can be realized by measuring communication rate while changing structures of the LSI design support device.

A specific measuring procedure is as follows. Having set a measuring sample time, a high load condition is created on a designated transfer. Then, measured data (register value) sampled in the controlling PC is read and calculated by an event counter function and a timer function within the LSI design support device. The measured data is implemented in the LSI design support device. Contents of the data includes, for example, a measured sample time (e.g., ms unit), a packet number of object TLP transfer within the measured sample time, and an occupation time of a TLP packet within the measured sample time. The transfer byte number per a certain time period can be calculated in the following equation using these measured data.

$$\text{Live data (payload) per a certain time period} = \text{TLP occupation time} - \text{TLP header}$$

$$= ((\text{occupation time} \times \text{transfer capacity per a certain time period}) - (\text{number of TLP} \times 12 \text{ [byte]}))$$

The LSI design support system of the present invention automatically analyzes a link structure that is necessary for realizing a transfer band required for the link between an object system (an existing system) and an LSI system for development, thereby leading to the most desirable PCI Express function block structure which is built in the LSI system for development. The PCI Express function block having the most desirable specification (e.g., a number of lanes, a number of stages of transmission/reception buffers and buffer capacity thereof) is realized in the LSI design support device. In this way, a virtual function block can be built. By using the information on a virtual PCI Express function block having the most desirable specification (e.g., a number of lanes, a number of stages of transmission/reception buffers and buffer capacity thereof), performance of an LSI can be evaluated before manufacturing an actual LSI.

In the next procedure, an application connection bus controller is controlled to perform a link operation between the virtual function block and an application function block. In this way, as a virtual LSI, a performance evaluation and a performance analysis can be performed. The most desirable interface procedure can be guided and also the most desirable interface procedure can be analyzed by connecting the function block and the application function block and analyzing operation information obtained by connecting the function block and the application function block.

On the other hand, information for constructing a real LSI system can be obtained by outputting information on the PCI Express function block having the most desirable specification (e.g., a number of lanes, a number of stages of transmission/reception buffers and buffer capacity thereof) via interface. By using the above information, an LSI system having the most desirable function block based on the PCI Express standard can be easily obtained. By using information on the PCI Express function block having the most desirable specification (e.g., a number of lanes, a number of stages of transmission/reception buffers and buffer capacity thereof), performance of an actual LSI system can be evaluated before constructing a real LSI system. An LSI system may be manufactured based on the LSI system design information which is updated based on information that is obtained by evaluating performance of the LSI system.

A method for determining the function block of the present invention, for example, comprises the steps of: establishing a link between an object system and the LSI design support device; measuring an inter-link communication speed by changing types and amount of packets transferred to the object system, while changing a lane structure and a buffer structure of the LSI design support device; and determining the most desirable buffer structure of the function block based on information obtained by the former step. Hereinafter, an example of a method for utilizing the LSI support device of the present invention will be explained.

The LSI design support device is connected to an object system (which will be connected to an LSI system). The LSI design support device acts as an interlink transfer device within a PCI Express system. By changing lane structures and buffer structures within the LSI design support device while measuring communication rate, the most desirable link structures (e.g., a number of lanes and buffer structures) can be determined.

Also, since the LSI design support device can change number of lanes and buffer structures, the LSI design support device can duplicate the PCI Express function block which will be built in the LSI system. The LSI design support device has an application function block which can be connected to the PCI Express function block, thus duplicated in the LSI design support device. Therefore, the LSI design support device can analyze the most desirable interface procedure by operating the PCI Express function block duplicated in the LSI design support device and the application function block and by observing the operations. In this way, the performance of the PCI Express function block or the LSI system having the PCI Express function block can be evaluated before an actual LSI system is manufactured.

Furthermore, the LSI design support device can manufacture an actual PCI Express function block by outputting information on the PCI Express function block obtained in the above way from an output part.

Also, the LSI design support device figures out and stores information on reception buffers and a response time of the object system when analyzing number of lanes and buffer structures. So the LSI design support device reproduces the reception buffers and response time of the object system by adjusting number of lanes and buffer structures, thereby being able to act as a pseudo model of the object system. Since the LSI design support device also has, for example, a structure for realizing high load transfer such as a DMA controller, the LSI design support device can create models by changing transfer amount of the pseudo model of the object system. Therefore, the LSI design support device can perform link evaluation between the LSI system and the object system in various situations. The LSI design support device is useful for designing an LSI and evaluating the function of LSI because the LSI design support device can change transfer situations and create anomaly situations arbitrarily.

In other words, the LSI design support device of the present invention can use an object system as a ROOT when optimizing the PCI Express link. On the other hand, after having built an actual LSI system, the object system can be used as a ROOT which is to be connected to the LSI system.

Outline of the PCI Express Standard

The present invention relates to application of the PCI Express (registered trademark) corresponding to one type of high speed serial bus. In the following, an outline of the PCI Express standard is described. A high speed serial bus refers to an interface that enables data exchange at high speed (i.e., at least 100 Mbps) through serial transmission using one transmission channel.

Port / Lane / Link

A port corresponds to a set of transmitters and receivers that are physically provided within the same semiconductor for establishing a link. The port realizes an interface for logically establishing one to one connection (point to point connection) between components. In the present example, the transmission rate is assumed to be 2.5 Gbps or 5 Gbps per direction (a transmission rate of 10 Gbps is expected to be realized in future applications). A lane corresponds to a set of 0.8 V differential signal pairs, including a transmission signal pair and a reception signal pair, for example. A link corresponds to a set of lanes establishing connection between two ports, and realizes a dual simplex communication bus between components. An xN link is made up of N lanes, and in the present standard, the number N is defined as N=1, 2, 4, 8, 16, or 32. By arranging the lane width N of the lanes to be adjustable, a scalable bandwidth may be obtained.

Root Complex

The root complex is arranged at an uppermost position of an I/O structure, and is configured to connect units, such as a CPU and a memory subsystem to the I/O structure. The root complex is often referred to as a memory hub. The root complex includes at least one PCI Express port (root port) that is configured to realize an independent I/O layer domain.

End Point

An end point corresponds to a device having a type 00h configuration space header. Specifically, an end point may correspond to a legacy end point or a PCI Express end point.

Switch

A switch is configured to connect at least two ports, and conduct packet routing between the connected ports.

PCI Express-PCI Bridge

In a PCI Express system, connection between the PCI Express and PCI/PCI-X devices are provided. In this way, PCI/PCI-X devices of a PCI system may be used in the PCI Express system.

Layer Architecture

PCI Express architecture includes independent layers each defining their individual specifications. Specifically, the PCI Express architecture includes software as an uppermost layer, a mechanical part as a lowest layer, and a transaction layer, a data link layer, and a physical layer provided in between the uppermost and lowermost layers.

Transaction Layer

The transaction layer corresponds to the uppermost layer of the three layers and is provided with functions for constructing and deconstructing a transaction layer packet (TLP). The transaction layer packet (TLP) is used for transmitting various transaction such as read/write transactions and other events. The transaction layer conducts flow control using credits for the transaction layer packet (TLP).

Data Link Layer

The data link layer is provided with functions for ensuring data completeness of the transaction layer packet (TLP) through error detection/correction (retransmission) and realizing link management. In the data link layer, packet exchange is conducted for realizing link management and flow control. The packet used in the data link layer is referred to as a data link layer packet (DLLP) to distinguish such a packet from the transaction layer packet (TLP).

Physical Layer

The physical layer includes circuits required for conducting interface operations such as a driver, an input buffer, a parallel-serial/serial-parallel converter, a PLL, and an impedance matching circuit, for example. The physical layer is provided with interface initialization and protection functions as logical functions. Also, the physical layer has a function of dissociating the data link layer and the transaction layer form the signal technology used in an actual link.
In the hardware configuration of the PCI Express, the so-called embedded clock technology is used in which a clock signal is not used, and clock timing is embedded in a data signal so that the clock timing may be extracted at a reception side based on cross points in the data signal.

Configuration Space

The PCI Express includes a 4096 bytes configuration space. In the PCI Express, access to the configuration space is realized through access to a flat memory space (configuration read/write), and bus / device / function / register members are mapped in memory address.
In the PCI Express configuration space, the first 256 bytes may be accessed as a PCI configuration space through the BIOS or from an OS using an I/O port, for example. Accordingly, a function of converting the access to the PCI into an access to the PCI Express is implemented in a host bridge. A PCI2.3 compatible configuration space header is provided from 00h to3Fh. In this way, a legacy OS or software that is originally implemented may be used for accessing functions other than the functions extended by the PCI Express. Specifically, in the software layer of the PCI Express, compatibility with the PCI load-store architecture (i.e., a scheme in which a processor directly accesses an I/O register) is maintained. However, in the case of using a function extended by the PCI Express (e.g., synchronous transmission, RAS (Reliability, Availability, and Serviceability)), access has to be made to the 4KB PCI Express extended configuration space.
Various form factors may be conceived for the PCI Express including the add-in card, the plug-in card (Express Card), and the Mini PCI Express card, for example.

Address Space and Transaction Type

In the PCI express, four address spaces are defined including a memory space (for data transmission with a memory space), an I/O space (for data transmission with the I/O space), and a configuration space (for setup with a device configuration) that are also defined in the PCI; and a message space that is additionally defined in the PCI Express. Transaction types are defined by the respective address spaces (i.e., read / write transactions are defined by the memory space, the I/O space, and the configuration space, and message transactions are defined by the massage space).

Transaction Layer Packet (TLP)

The PCI Express realizes communication in packet units. Referring to the transaction layer packet (TLP) format, a header having a length of 3 DW (12 bytes) or 4 DW (16 bytes) (DW: double word) is provided, the header including information on the format of the transaction layer packet (e.g., header length, the presence of a payload), the transaction type, the traffic class (TC), attributes, and the payload length, for example. The maximum payload length within the packet is 1024 DW (4096 bytes).

The ECRC (End-to-end Cyclic Redundancy Checksum) is provided for ensuring end-to-end data completeness, and corresponds to a 32-bit CRC of the transaction layer packet. When an error occurs at the transaction layer packet (TLP) within the switch, such as an error may not be detected in the LCRC (Link CRC) since the LCRC is recalculated at the TLP.

Traffic Class (TC) and Virtual Channel (VC)

Traffic class (TC) information may be used by the upper software layer to distinguish (prioritize) traffic. For example, transmission of graphic data may be prioritized over network data. Eight traffic classes TC0 to TC7 are provided.

Virtual channels (VC) correspond to virtual communication buses (mechanism using plural independent data flow buffers sharing the same link) that each have resources (e.g., buffers or queues) and are arranged to conduct independent flow control operations. In this way, even when a buffer of one virtual channel is full, data transmission may be conducted using another virtual channel. In other words, by dividing one physical link into plural virtual channels, efficient use of resources may be realized. For example, when the link of a root branches out to plural devices via a switch, traffic priority for each of the devices may be controlled. The virtual channel VC0 corresponds to a default virtual channel that is required in the system, and other virtual channels (e.g., VC1 to VC7) may be provided according to a tradeoff between cost and performance.

In the transaction layer, the traffic classes (TC) are mapped to the virtual channel(s) (VC). One or more traffic classes (TC) may be mapped to a virtual channel according to the number of virtual channels being provided. As two simple examples, each traffic class (TC0 to TC7) may be mapped to each virtual channel (VCO to VC7) on a one-to-one basis, or all the traffic classes (TC0 to TC7) may be mapped to a single virtual channel (VCO). The mapping of TC0 to the virtual channel VC0 is a prerequisite, whereas the mapping of the other traffic classes (TC1 to TC7) may be controlled by the upper software layer. The software layer may use the traffic class (TC) information to control the priority of transactions.

Flow Control

Flow control (FC) is conducted in order to avoid congestion and overflow of the reception buffer, and to set a transmission order. The flow control is conducted on a point-to-point basis between links rather than on an end-to-end basis. Therefore, it may not be confirmed through such flow control that a packet has actually been received at the communication counterpart (completer).

In the PCI Express, credit-based flow control is conducted. That is, the PCI Express implements a mechanism for preventing overflow or underflow by checking the state of the buffer at the reception side before starting data transmission. More specifically, at the time of link initialization, the reception side informs the transmission side of its buffer capacity (credit value). In turn, the transmission side compares the credit value with the length of the packet it intends to send to the receiving side, and conducts the packet transmission only when the credit value exceeds the transmission packet length by a predetermined value.

Information exchange with respect to flow control is realized using the data link layer packet (DLLP) of the data link layer. The flow control is only conducted on the transaction layer packet (TLP) so that the data link layer packet (DLLP) may be transmitted at all times (i.e., the data link layer packet is not subject to flow control).

Handling of the Transaction Layer Packet (TLP)

At the data link layer, a 2-byte sequence number and a 4-byte link CRC (LCRC) are respectively attached to the front end and rear end of a transaction layer packet (TLP) received form the transaction layer, after which the packet is handed to the physical layer. The transaction layer packet (TLP) is stored in a retry buffer until reception confirmation (ACK) is received from the reception side. When the transmission of the transaction layer packet successively fails, it may be determined that there is a link abnormality, and a link retraining request may be sent to the physical layer. When link training failure is detected, the data link layer is switched to an inactive state.

On the other hand, with respect to a transaction layer packet (TLP) received from the physical layer, the sequence number and the link CRC (LCRC) of the transaction layer packet (TLP) from the physical layer are evaluated at the data link layer, and the transaction layer packet (TLP) is handed to the transaction layer if no abnormalities are detected. If an error is detected, a retransmission request is sent to the physical layer.

Data Link Layer Packet (DLLP)

A packet generated by the data link layer is referred to as a data link layer packet (DLLP) and is exchanged within the data link layer. The data link layer packet has a packet length of 6 bytes, and includes information indicating the type of DLLP (1 byte), unique information in conjunction with the type of DLLP (3 bytes), and CRC (2 bytes).

Physical Layer - Logical Sub Block

The physical layer includes a logical sub block. The primary task of the logical sub block of the physical layer is to convert a packet received form the data link layer into a format suited for transmission by an electrical sub block. Also, the logical sub block has the function of controlling and managing the physical layer.

Data Coding and Parallel-to-Serial Conversion

The PCI Express uses 8B/10B conversion for data coding so that long successions of "0"s and "1"s do not occur (i.e., so that an absence of cross points does not last for a long period of time). The converted data are serially converted to be transmitted from an LSB onto a lane. In a case where plural lanes are provided, data are assigned to the respective lanes in byte units before being encoded. The illustrated example appears to correspond to a parallel bus transmission; however, an independent transmission is realized in each of the lanes so that problems such as skew that are created in the parallel bus may be alleviated.

The present invention can be preferably used in the field of semiconductor (LSI) manufacturing industry.

The foregoing detailed description has set forth a few of the many forms that the invention can take. It is intended that the foregoing detailed description be understood as an illustration of selected forms that the invention can take and not as a limitation to the definition of the invention. It is only the claims, including all equivalents that are intended to define the scope of this invention.

**Claims**

1. A method for designing an LSI (Large Scale Integration) system having a high speed serial bus and a function block for realizing the high speed serial bus, comprising:

    connecting an LSI design support device with an object system, the object system to be connected to the LSI system; and
    by the LSI design support device determining a most desirable number of stages of transmission/reception buffers and a most desirable transmission/reception buffer capacity for a first function block,

    wherein the determination includes measuring a link communication rate between the LSI design support device and the object system by monitoring a number of transmission packets or reception packets, the transmission packets being transmitted to the object system, and by monitoring a response time of the object system to the packets, while changing a number of stages of transmission/reception buffers and a transmission/reception buffer capacity of the LSI design support device.

2. The method of claim 1, wherein the high speed serial bus is at least a high speed serial bus based on a PCI Express standard.

3. The method of claim 1, further comprising:

    building a second function block within the LSI design support device, wherein the second function block having the most desirable number of lanes, the most desirable number of stages of a transmission/reception buffer, and the most desirable transmission/reception buffer capacity for the function block, the second function block having the same function as the first function block to be built in the LSI system.

4. The method of claim 3, further comprising:

    manufacturing a virtual LSI system using the LSI design support system, the virtual LSI system comprising an application function block, the application function block is being used for the LSI system, wherein manufacturing the virtual LSI system includes connecting an application function block and the second function block.

5. The method of claim 4, further comprising performing performance evaluation for the LSI system using an LSI design support device, wherein the LSI design support device comprises the virtual LSI system.

6. The method of claim 5, further comprising:

   outputting a design parameter for an LSI system obtained by the performance evaluation; and
   manufacturing an actual LSI system by using the outputted design parameter for the LSI system.

7. The method of claim 6, wherein manufacturing the virtual LSI, further comprising:

   obtaining information on reception buffer structures of the object system;
   measuring a response speed of the object system; and
   changing the number of lanes and transmission/reception buffer structures of the LSI design support device
   according to the obtained reception buffer structures and the response speed,
   thereby building a virtual object system within the LSI design support device, the system being able to be
   connected with an actual LSI system.

8. The method of claim 7, further comprising:

   connecting the virtual object system and the LSI system; and
   evaluating performance of the LSI system by changing at least one of: a number of lanes, a number of stages
   of transmission/reception buffers, a transmission/reception buffer capacity, and a transmission load capacity of
   the virtual object system.

9. A method for designing an LSI system having a high speed serial bus and a function block for realizing the high
   speed serial bus, comprising:

   connecting an LSI design support device with an object system, the object system to be connected to the LSI
   system; and
   by the LSI design support device determining a most desirable number of lanes and a most desirable transmission/reception buffer structure,

   wherein the determination includes:

   calculating an effective transmission rate of each lane by considering an overhead of a communication packet
   header, the overhead being set at each link of the LSI design support device, and
   calculating a required number of lanes by comparing the effective transmission rate and an effective transmission
   rate per lane, where the calculations are performed so that, when number of lanes currently establishing links
   is supposed to be the maximum number of lanes, the number of lanes becomes no more than the maximum
   number of lanes and satisfies a required transmission band; and
   monitoring a number of transmission packets or reception packets and response time to the packets, while
   changing the number of lanes of the LSI design support device and changing headers and payload size of the
   transmission/reception buffers of the LSI design support device.

10. An LSI system design support device for designing an LSI system having a high speed serial bus and a function
    block for realizing the high speed serial bus, comprising:

    a high speed serial bus to be connected with a high speed serial bus of an object system, the object system to
    be connected to the LSI system;
    a means for reading information from the object system, the information including a maximum number of lanes
    for the high speed serial bus, transmission/reception buffer information of the function block, a maximum reading
    capacity of the object system, and a maximum payload capacity of the object system;
    a means for changing a number of lanes of the high speed serial bus, the high speed serial bus to be connected
    with the object system;
    a means for changing a number of stages of transmission/reception buffers and transmission/reception buffer
    capacity;
    a means for monitoring a number of a transmission packet or a reception packet and response time of an LSI
    system to the packets;
    a means for analyzing a number of a transmission packet or a reception packet and communication speed of
    the object system to the packets based on the monitored response time; and
    a means for determining a most desirable number of stages of transmission/reception buffers and a most desirable transmission/reception buffer capacity for the function block based on the analysis result.

**11.** The design support device of claim 10, wherein the high speed serial bus is at least a high speed serial bus based on a PCI Express standard.

Fig.1

PC

P C Ie design support system

PC IF

processor

memory controller

Memory

Timer

DMA controller

application connection bus controller

application function block

PCIe function block

PCIe link

PCIe bus

PCIe slot

connection component

object system

13

**EUROPEAN SEARCH REPORT**

Application Number

EP 08 15 7293

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ALTERA: "PCI Express High Performance Reference Design"[Online] May 2007 (2007-05), XP002497827 Retrieved from the Internet: URL:http://www.altera.com/literature/an/an456.pdf> [retrieved on 2008-09-28] * page 1 - page 8 * * page 10 - page 12 * ----- | 1-11 | INV. G06F17/50 |
| A | US 2005/114556 A1 (SOLOMON RICHARD L [US] ET AL) 26 May 2005 (2005-05-26) * abstract * * paragraph [0001] - paragraph [0007] * ----- | 1-11 | |

TECHNICAL FIELDS SEARCHED (IPC)

G06F

The present search report has been drawn up for all claims

| Place of search | Date of completion of the search | Examiner |
|---|---|---|
| Munich | 30 September 2008 | Radev, Boyan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

## ANNEX TO THE EUROPEAN SEARCH REPORT
## ON EUROPEAN PATENT APPLICATION NO.

EP 08 15 7293

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2008

| Patent document cited in search report | Publication date | Patent family member(s) | Publication date |
|---|---|---|---|
| US 2005114556 A1 | 26-05-2005 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007147520 A